# EUROPEAN PATENT APPLICATION

(11) **EP 4 365 484 A1**
(43) Date of publication of application: **08.05.2024**
(21) Application number: 21953877.4
(22) Date of filing: 31.08.2021
(51) Int. Cl.: F21S 41/30, F21S 41/25, F21S 41/36, F21S 41/24

(54) **ADB HIGH AND LOW BEAM INTEGRATED VEHICLE LAMP ILLUMINATION MODULE AND VEHICLE LAMP**

(30) Priority: 20.08.2021 CN 202110963004
(71) Applicant: Hasco Vision Technology Co., Ltd., Jiading District Shanghai 201821 (CN)
(72) Inventor: ZHANG, Jie, Shanghai 201821 (CN); CHEN, Jiayuan, Shanghai 201821 (CN); DONG, Shikun, Shanghai 201821 (CN); ZHU, He, Shanghai 201821 (CN); SANG, Wenhui, Shanghai 201821 (CN)
(74) Representative: SSM Sandmair
(86) International application number: PCT/CN2021/115676
(87) International publication number: WO 2023/019640

(57) **Abstract**

An ADB high and low beam integrated vehicle lamp illumination module, comprising a low beam primary optical unit (1), a high beam primary optical unit (2), a light shielding plate (3), and a collimating optical element (4). The low beam primary optical unit (1) comprises a low beam light source (11) and a low beam condensing element (12) used for collimating or converging light emitted by the low beam light source (11) and forming a low beam light distribution in the focal region of the collimating optical element (4); the high beam primary optical unit (2) comprises a plurality of high beam light sources (21), a high beam condensing element (22), and a bifocal optical element (23); the high beam condensing element (22) is suitable for collecting light emitted by the plurality of high beam light sources (21) and the light is irradiated to the region of a first focus (F1) of the bifocal optical element (23); a second focus (F2) of the bifocal optical element (23) is located in the focal region of the collimating optical element (4); the light shielding plate (3) is disposed in the focal region of the collimating optical element (4). A low beam light shape and an ADB light shape consisting of the low beam light shape and an ADB illuminated region having a cut-off line can be formed, and an illuminated dark region formed by the ADB light shape is smaller.

## Description

### Cross-reference to Related Applications

The present application claims priority to the Chinese Patent Application No. 202110963004.X filed on August 20, 2021, which is hereby incorporated by reference in its entirety.

### Field of the Invention

The present invention relates to a vehicle lamp, in particular to an ADB high and low beam integrated vehicle lamp illumination module. The present invention further relates to a vehicle lamp.

### Background of the Invention

A vehicle lamp illumination module is divided into a high beam illumination module, a low beam illumination module, and a high and low beam integrated illumination module according to its different purposes. In addition, the vehicle lamp illumination module can also be divided into a reflective illumination module and a projective illumination module according to the forming principle of its illumination light shape. The projective illumination module is generally composed of a light source, a quasi ellipsoidal reflector, and a collimating lens. In an illumination module with a low beam illumination function, a light shielding plate further needs to be disposed near a focus of the collimating lens to form a low beam illumination light shape with a cut-off line (an upper boundary of the illumination light shape). In the high and low beam integrated projective illumination module, it is usually necessary to dispose an actuator to drive the light shielding plate for position switching, so as to form high and low beam illumination light shapes respectively.

In an ADB high and low beam integrated vehicle lamp illumination module, due to the fact that an ADB high beam module usually contains a plurality of high beam illumination light sources and a plurality of quasi ellipsoidal reflectors, or a plurality of high beam illumination light sources and a condenser with a plurality of light incident surfaces, so as to form an ADB high beam light distribution at a focus of the collimating lens, while a low beam module usually contains a low beam light source and a low beam primary optical element so as to form a low beam light distribution at a focus of the collimating lens. The collimating lens projects the ADB high beam light distribution to form an ADB high beam light shape, and projects the low beam light distribution to form a low beam light shape. In order to form the clear ADB high beam light shape and the clear low beam light shape, the high beam light source, the quasi ellipsoidal reflector or the condenser, the low beam light source, and the low beam primary optical element all need to be disposed on or near an optical axis of the collimating lens, which will cause interference between the high beam light source as well as the quasi ellipsoidal reflector or the condenser, and the low beam light source and the low beam primary optical element. In particular, the quantity and volume of the high beam light source of the ADB high beam and the quasi ellipsoidal reflector or the condenser are relatively large, which increases an interference with the low beam light source and the low beam primary optical element, causing the high beam light source and/or the low beam light source to deviate from the optical axis of the collimating lens, affecting a clarity of the ADB high beam light shape and/or low beam light shape.

In order to reduce the interference between the ADB high beam module and the low beam module in the ADB high and low beam integrated vehicle lamp illumination module, there is also a technical solution where a separate low beam module is not disposed in the ADB high and low beam integrated vehicle lamp illumination module, but a light shielding plate is disposed at the focus of the collimating lens, the ADB high beam light shape is shielded through the light shielding plate so as to form a low beam light shape with a bright-dark cut-off line, and a position of the light shielding plate is switched to a focus away from the collimating lens so as to form the ADB high beam light shape. However, in this technical solution, not only is it necessary to dispose the actuator to drive the light shielding plate for position switching, resulting in defects of low switching speed and high switching noise, but also in order to cover a low beam illumination region, the ADB high beam light shape has a large illumination range. In a process of the execution of ADB, an ADB illuminated dark region formed includes both regions above and below the low beam cut-off line, resulting in an excessive large dark region and a lack of illumination in the low beam illumination region, affecting an observation effect of a vehicle driver on the road surface, and forming safety hazards for vehicle driving.

### Summary of the Invention

The technical problem to be solved by the present invention is to provide an ADB high and low beam integrated vehicle lamp illumination module, which can avoid interference between a high beam optical element and a low beam optical element, and has clearer high and low beam light shapes.

The further technical problem to be solved by the present invention is to provide a vehicle lamp, and the optical elements of the vehicle lamp have no interference and have high light shape clarity.

In order to solve the above technical problems, an aspect of the present invention provides an ADB high and low beam integrated vehicle lamp illumination module, including a low beam primary optical unit, a high beam primary optical unit, a light shielding plate and a collimating optical element, wherein the low beam primary optical unit includes a low beam light source and a low beam condensing element, the low beam condensing element is suitable for collecting light emitted by the low beam light source so as to form a low beam light distribution in a focal region of the collimating optical element, the high beam primary optical unit includes a plurality of high beam light sources, a high beam condensing element and a bifocal optical element, the high beam condensing element is suitable for collecting light emitted by the plurality of high beam light sources and the light is irradiated to a region of a first focus of the bifocal optical element, a second focus of the bifocal optical element is disposed in the focal region of the collimating optical element, a cut-off line structure is disposed on one side of the light shielding plate, and the cut-off line structure is disposed in the focal region of the collimating optical element.

Preferably, the high beam condensing element is a parabolic reflector, the plurality of high beam condensing elements are provided, each high beam light source is respectively disposed in the focal region of one corresponding high beam condensing element, and reflecting surfaces of the plurality of high beam condensing elements are all disposed in the region of the first focus of the bifocal optical element. Through the preferred technical solution, the light emitted by each high beam light source can be reflected by the corresponding parabolic reflector to form parallel collimated light. The collimated light formed by reflecting the light emitted by the plurality of high beam light sources through each corresponding parabolic reflector is combined to form a primary light distribution of an ADB light shape. Through the arrangement that reflecting surfaces of the plurality of high beam condensing elements are all disposed in the region of the first focus of the bifocal optical element, the bifocal optical element can convert the primary light distribution of the ADB light shape formed by the reflection of the plurality of high beam condensing elements to a region of the second focus, so as to form secondary light distribution of the ADB light shape, which is collimated by the collimating optical element and then projected onto a road surface, forming a clear ADB illumination light shape.

Further preferably, the plurality of bifocal optical elements are provided, and the region of the first focus of each bifocal optical element is provided with one or more high beam condensing elements. In the preferred technical solution, due to the use of the plurality of bifocal optical elements, the quantity of high beam condensing elements corresponding to each bifocal optical element is reduced, which can make the primary light distribution formed by each high beam condensing element closer to the region of the first focus of the bifocal optical element, improving a conversion effect of the bifocal optical elements on the primary light distribution and clarity of the finally formed ADB illumination light shape.

Preferably, the high beam condensing element is a transparent optical guide condensing piece, the transparent optical guide condensing piece includes a plurality of light incident surfaces, each light incident surface of the transparent optical guide condensing piece is provided with one high beam light source, and a light exit surface of the transparent optical guide condensing piece is disposed in the region of the first focus of the bifocal optical element. Through the preferred technical solution, the transparent optical guide condensing piece can introduce the light emitted by the plurality of high beam light sources from the plurality of light incident surfaces, emit the light from the same light exit surface, and form the primary light distribution in the region of the first focus of the bifocal optical element.

Preferably, the high beam condensing element is an ellipsoidal reflector, the plurality of high beam condensing elements are provided, each high beam light source is disposed in one focus of one high beam condensing element, and the other focuses of the plurality of high beam condensing elements are all disposed in the region of the first focus of the bifocal optical element. In the preferred technical solution, the ellipsoidal reflector has two focuses. The ellipsoidal reflector is capable of converging light emitted from one focus to the other focus. The ellipsoidal reflector has a better convergence effect on the light, helping to improve the clarity of an illumination region formed by the light emitted by each high beam light source and improving resolution of the ADB high beam light shape.

As a preferred solution, the bifocal optical element is an ellipsoidal reflector. In the preferred technical solution, the ellipsoidal reflector can reflect incident light emitted from different directions to one focus to the other focus, which has less restriction on the direction of the incident light and has more flexible position setting of the ellipsoidal reflector and its first focus.

Preferably, the bifocal optical element is a convex lens or a lens group. In the preferred technical solution, the convex lens or the lens group is capable of converging light emitted from a focus on one side to a focus on the other side, thereby reflecting incident light emitted from different directions in the region of the focus on one side to one focus to the other focus. The convex lens or the lens group has a simple structure, convenient processing, and relatively low costs of use.

Preferably, the low beam condensing element is an ellipsoidal reflector, the low beam light source is disposed in one focus of the low beam condensing element, and the other focus of the low beam condensing element is disposed in the focal region of the collimating optical element. In the preferred technical solution, the ellipsoidal reflector can reflect incident light emitted from different directions to one focus to the other focus, which can better collect divergent light emitted by the high beam light source and can form a clearer low beam light distribution in the region of the first focus of the collimating optical element.

Further preferably, the plurality of low beam light sources and the plurality of low beam condensing elements are provided, each low beam light source is disposed in a first focus of one low beam condensing element, and second focuses of the plurality of low beam condensing elements are all located in the focal region of the collimating optical element. Through the preferred technical solution, the plurality of low beam condensing elements can converge the light emitted by the low beam light sources set at each corresponding first focus to the focal region of the collimating optical element, and the light emitted by different low beam light sources is combined and stacked with each other in the focal region of the collimating optical element, so as to form the low beam light distribution.

Preferably, the low beam condensing element is a transparent optical guide condensing piece, and the low beam light source is disposed on the light incident surface of the low beam condensing element. In the preferred technical solution, the light emitted by the low beam light source can enter the transparent optical guide condensing piece through the light incident surface, and after being refracted and reflected by the transparent optical guide condensing piece, the light emitted by the low beam light source is emitted from the light exit surface of the transparent optical guide condensing piece, so as to form the low beam light distribution in the focal region of the collimating optical element.

Preferably, the collimating optical element is a parabolic reflector or a convex lens. In the preferred technical solution, either the parabolic reflector or the convex lens can project the light distribution at its focus, so as to form an illumination light shape. A light incident direction and projection direction of the parabolic reflector can form a small included angle, while a projection direction of the convex lens is basically the same as the light incident direction.

A second aspect of the present invention provides a vehicle lamp that utilizes the ADB high and low beam integrated vehicle lamp illumination module provided by the first aspect of the present invention.

Through the above technical solution, according to the ADB high and low beam integrated vehicle lamp illumination module of the present invention, the low beam condensing element can converge light emitted by the low beam light source to the focal region of the collimating optical element, and after being shielded by the light shielding plate, the light is projected out through the collimating optical element, so as to form the low beam light shape with a bright-dark cut-off line on an upper part. The light emitted by each high beam light source is collimated or converged by the high beam condensing element, and then is irradiated to the region of the first focus of the bifocal optical element, so as to form a part of the ADB primary light distribution. The light emitted by a plurality of high beam light sources is combined in the region of the first focus of the bifocal optical element to form the complete ADB primary light distribution. The bifocal optical element can convert the ADB primary light distribution in the region of the first focus to the region of the second focus, namely, the focal region of the collimating optical element, thus forming the ADB secondary light distribution. The ADB secondary light distribution is shielded by the light shielding plate and then projected out through the collimating optical element, so as to form an ADB high beam illumination region with a bright-dark cut-off line in a lower part. The ADB high beam illumination region is combined with the low beam light shape to form the ADB high beam light shape. In the ADB high and low beam integrated vehicle lamp illumination module of the present invention, due to the fact that the bifocal optical element can convert the light distribution in the region of the first focus to the region of the second focus, the second focus of the bifocal optical element may be disposed at the focus of the collimating optical element, and the first focus may be disposed outside the optical axis of the collimating optical element, so that the high beam primary optical unit may be disposed outside the optical axis of the collimating optical element, avoiding mutual interference between the high beam primary optical unit and the low beam primary optical unit disposed near the optical axis of the collimating optical element. The ADB high beam light shape formed by the ADB high beam and low beam integrated vehicle lamp illumination module of the present invention is formed by the combination of the ADB high beam illumination region and the low beam light shape. When performing an ADB function to extinguish a certain high beam light source, the formed illuminated dark region is only the region above the bright-dark cut-off line of the low beam light shape, which does not affect observation of a vehicle driver of the low beam illumination region and improves the safety of vehicle driving. The ADB high and low beam integrated vehicle lamp illumination module of the present invention only needs to control on-off of the high beam light source when switching between the high beam light shape and the low beam light shape, without the need to move the light shielding plate. The switching speed of the high beam light shape and the low beam light shape is higher, the stability of the high beam light shape and the low beam light shape is higher, and there is no switching noise. The vehicle lamp of the present invention also has the above advantages due to the use of the ADB high and low beam integrated vehicle lamp illumination module of the present invention.

Other technical features and effects of the present invention will be further explained in the specific implementations below.

### Brief Description of the Drawings

Figure 1 is a three-dimensional view of an assembly of an embodiment of an ADB high and low beam integrated vehicle lamp illumination module of the present invention after assembling.
Figure 2 is a front view of Figure 1.
Figure 3 is a schematic cross-sectional view of an A-A orientation in Figure 2.
Figure 4 is an exploded view of a part in Figure 1.
Figure 5 is a schematic diagram of an embodiment of an ADB high and low beam integrated vehicle lamp illumination module of the present invention and a high beam light path.
Figure 6 is a schematic diagram of an embodiment of an ADB high and low beam integrated vehicle lamp illumination module of the present invention and a low beam light path.
Figure 7 is a screen illuminance diagram of a low beam light shape formed by an embodiment of an ADB high and low beam integrated vehicle lamp illumination module of the present invention.
Figure 8 is a screen illuminance diagram of an ADB high beam illumination region formed by an embodiment of an ADB high and low beam integrated vehicle lamp illumination module of the present invention.
Figure 9 is a screen illuminance diagram of an ADB high beam light shape formed by an embodiment of an ADB high and low beam integrated vehicle lamp illumination module of the present invention.
Figure 10 is a screen illuminance diagram of an ADB high beam light shape with an illuminated dark region formed by an embodiment of an ADB high and low beam integrated vehicle lamp illumination module of the present invention.
Figure 11 is a schematic diagram of a light path of a bifocal optical element in an ADB high and low beam integrated vehicle lamp illumination module of the present invention.
Figure 12 is a schematic diagram of a light path of another bifocal optical element in an ADB high and low beam integrated vehicle lamp illumination module of the present invention.
Figure 13 is a schematic diagram of an embodiment of an ADB high and low beam integrated vehicle lamp illumination module of the present invention and a high beam light path.
Figure 14 is a schematic diagram of another embodiment of an ADB high and low beam integrated vehicle lamp illumination module of the present invention and a high beam light path.
Figure 15 is a schematic diagram of another embodiment of an ADB high and low beam integrated vehicle lamp illumination module of the present invention and a high beam light path.
Figure 16 is a schematic diagram of yet another embodiment of an ADB high and low beam integrated vehicle lamp illumination module of the present invention and a high beam light path.
Figure 17 is a schematic diagram of further another embodiment of an ADB high and low beam integrated vehicle lamp illumination module of the present invention and a low beam light path.

**Description of reference numerals**

| | | | |
|---|---|---|---|
| 1 | low beam primary optical unit | 11 | low beam light source |
| 12 | low beam condensing element | 2 | high beam primary optical unit |
| 21 | high beam light source | 22 | high beam condensing element |
| 23 | bifocal optical element | 3 | light shielding plate |
| 31 | cut-off line structure | 4 | collimating optical element |
| 5 | lens support | 6 | radiator |

### Detailed Description of the Embodiments

In the present invention, without any contrary explanation, an orientation or positional relationship indicated by directional words such as "front, rear, top, bottom, left, right" is an orientation or positional relationship based on the fact that the ADB high and low beam integrated vehicle lamp illumination module is installed on a vehicle normally. A direction indicated by the directional word "front" is a direction when the vehicle is traveling normally. The description of the orientation or positional relationship of the ADB high and low beam integrated vehicle lamp illumination module, a vehicle lamp and its parts of the present invention is consistent with their installation orientation in actual use.

Terms such as "first" and "second" are only used for descriptive purposes, and cannot be understood as indicating or implying relative importance or implicitly indicating the quantity of the indicated technical features. Therefore, features limited to "first" and "second" can explicitly or implicitly include one or more of the features.

In the description of the present invention, it should be noted that unless otherwise expressly stated and limited, terms "install", "dispose" or "connect" should be understood in a broad sense, for example, the term "connect" may be a fixed connection, or a detachable connection, or an integrated connection; and may be a direct connection, or an indirect connection through an intermediate media, or internal connection of the two elements or an interaction relationship between the two elements. Those ordinarily skilled in the art may understand the specific meaning of the above terms in the present invention according to the specific situation.

The specific implementations of the present invention are illustrated in detail below in conjunction with accompanying drawings. It should be understood that the specific implementations described here are only used to illustrate and explain the present invention, and the scope of protection of the present invention is not limited to the specific implementations described below.

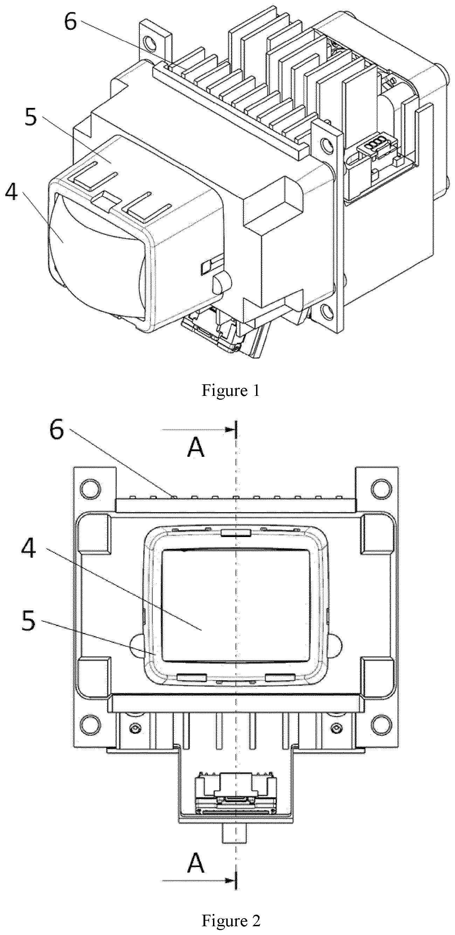

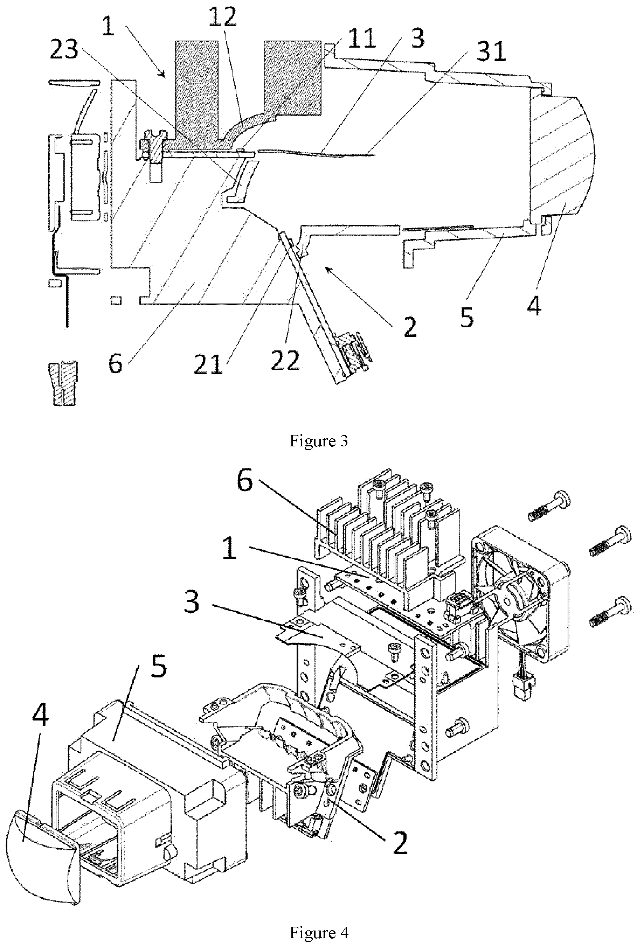

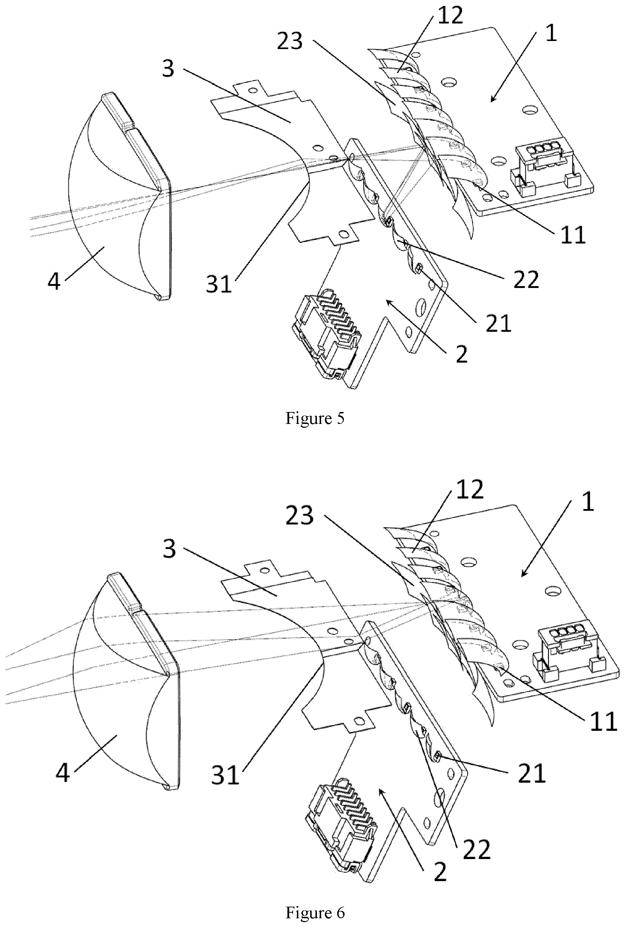

As shown in Figure 1 to Figure 17, an embodiment of an ADB high and low beam integrated vehicle lamp illumination module of the present invention includes a low beam primary optical unit 1, a high beam primary optical unit 2, a light shielding plate 3, and a collimating optical element 4. The low beam primary optical unit 1 is used for emitting low beam light and generating a low beam light distribution required by a low beam light shape. The low beam primary optical unit 1 includes a low beam light source 11 and a low beam condensing element 12. The condensing element is an optical element that can collect the light emitted by the light source and form a certain light distribution. Specifically, the condensing element may be a parabolic reflector with a parabolic reflecting surface or a quasi parabolic reflecting surface, may be an ellipsoidal reflector with an ellipsoidal reflecting surface or a quasi ellipsoidal reflecting surface, may also be a transparent optical guide condensing piece, a convex lens, or a lens group, and may further be a possible combination of the above optical elements. The quasi parabolic reflecting surface is a reflecting surface that is functionally similar to a parabolic reflecting surface and formed by adaptive adjustment on the basis of the parabolic reflecting surface, adjustment on the parabolic reflecting surface can adjust a reflection direction of a local reflecting surface so as to adjust light distribution formed by the reflected light. The quasi ellipsoidal reflecting surface refers to a reflecting surface that is functionally similar to the ellipsoidal reflecting surface and formed by adaptively adjusting a reflection direction of its local reflecting surface and formed light distribution on the basis of the ellipsoidal reflecting surface. The transparent optical guide condensing piece may be a traditional condenser structure formed by a transparent optical conductor, and may also be any other structural forms formed by the transparent optical conductor and capable of collecting, conducting, and outputting the light. The transparent optical guide condensing piece has a light incident surface and a light exit surface, and can introduce the light emitted by the light source through the light incident surface. After being collimated by the transparent optical conductor, the light is emitted from the light exit surface. The light incident surface may be a plane or curved surface set on the transparent optical guide condensing piece, and may also be a part of a light incident structure set on the transparent optical guide condensing piece. According to the different types of condensing elements, the light source is disposed at different relative positions of the condensing elements: when the condensing element uses the parabolic reflector, the light source is disposed at a focus of the parabolic reflector; when the condensing element uses the ellipsoidal reflector, the convex lens, or the lens group, the light source is disposed at a focus of the ellipsoidal reflector, the convex lens, or the lens away from the collimating optical element 4; and when the condensing element uses the transparent optical guide condensing piece, the light source is disposed at the light incident surface of the transparent optical guide condensing piece. The low beam condensing element 12 is a condensing element used in the low beam primary optical unit 1. The light emitted by the low beam light source 11 is converged or collimated by the low beam condensing element 12, and then forms a low beam light distribution in a focal region of the collimating optical element 4.

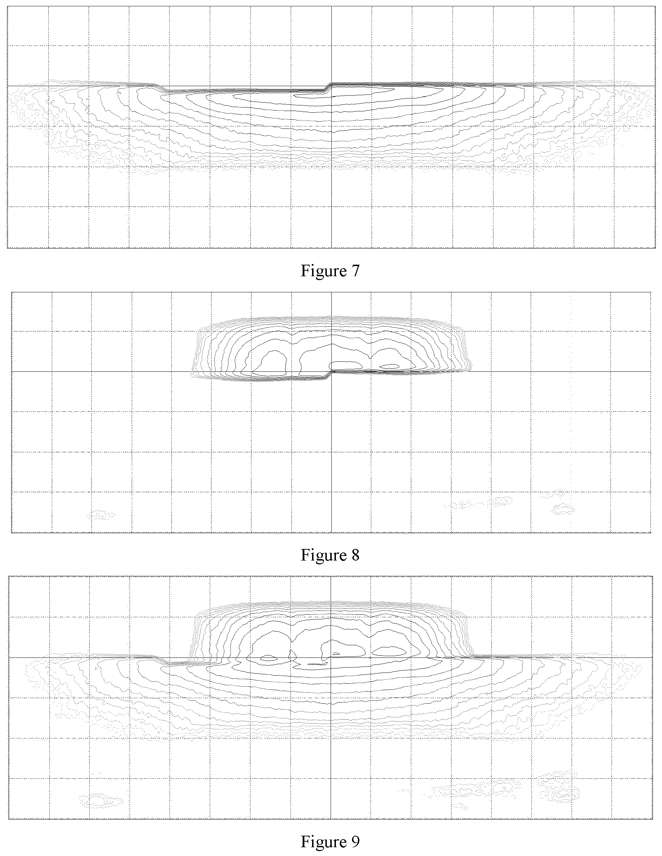

The light shielding plate 3 is horizontally disposed on an optical axis of the collimating optical element 4, a front end of the light shielding plate 3 is provided with a cut-off line structure 31, and the cut-off line structure 31 is disposed in the focal region of the collimating optical element 4. After the light shielding plate 3 shields the low beam light distribution, the low beam light distribution that is not shielded by the light shielding plate 3 is projected out through the collimating optical element 4, so as to form a low beam light shape with a bright-dark cut-off line in an upper part as shown in Figure 7. The cut-off line structure 31 is disposed in the focal region of the collimating optical element 4, which can make the formed bright-dark cut-off line clearer.

The collimating optical element 4 may use the parabolic reflector with the parabolic reflecting surface or the quasi parabolic reflecting surface, and may also use the convex lens or the lens group. When the collimating optical element 4 uses the convex lens or the lens group, the convex lens or the lens group may be installed on a lens support 5. The optical axis of the collimating optical element 4 refers to a symmetry axis of the collimating optical element 4. When the light is emitted to the collimating optical element 4 along the optical axis of the collimating optical element 4, after being transmitted or reflected by the collimating optical element 4, the light still propagates on an original straight line. If the collimating optical element 4 is the parabolic reflector, the optical axis of the collimating optical element 4 is a straight line passing through a focus F of the reflector and perpendicular to a tangent plane at a maximum curvature of a reflecting surface of the parabolic reflector. If the collimating optical element 4 is the convex lens or the lens group, the optical axis of the collimating optical element 4 is usually a straight line passing through two focuses of the convex lens or the lens group.

The high beam primary optical unit 2 is used for emitting ADB high beam light and generating light distribution required by an ADB high beam light shape. The high beam primary optical unit 2 includes a plurality of high beam light sources 21, one or more high beam condensing elements 22, and one or more bifocal optical elements 23. The high beam condensing element 22 is a condensing element applied in the high beam primary optical unit 2. One or more high beam condensing elements 22 can collect the light emitted by the plurality of high beam light sources 21 and can collimate or converge divergent light emitted by the plurality of high beam light sources 21, so as to form a plurality of light distributions with bright-dark boundaries on both of left and right sides. The plurality of light distributions are irradiated to a region of a first focus F 1 of the bifocal optical element 23 and are combined with each other to form an ADB primary light distribution.

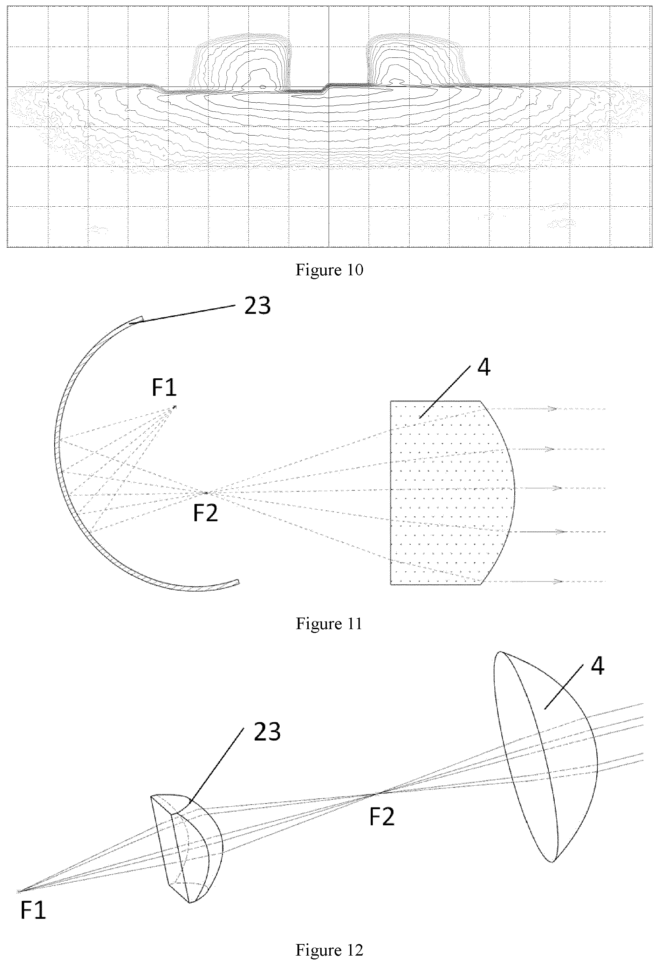

The bifocal optical element 23 is an optical element with the first focus F1 and a second focus F2. Specifically, the bifocal optical element 23 may be the ellipsoidal reflector with the ellipsoidal reflecting surface or the quasi ellipsoidal reflecting surface as shown in Figure 11, may also be the convex lens or the lens group with two focuses as shown in Figure 12, and may also be other possible optical elements or optical element groups with two focuses. According to the position setting requirements, either of the two focuses of the bifocal optical element may be used as the first focus F1, and the other focus may be used as the second focus F2. The bifocal optical element 23 can convert the ADB primary light distribution in the region of the first focus F1 to a region of the second focus F2, so as to form an ADB secondary light distribution. After the light shielding plate 3 shields the ADB secondary light distribution, the ADB secondary light distribution that is not shielded by the light shielding plate 3 is projected out through the collimating optical element 4, so as to form an ADB high beam illumination region with a bright-dark cut-off line in a lower part as shown in Figure 8. The second focus F2 of the bifocal optical element 23 is disposed in the focal region of the collimating optical element 4, making the ADB high beam illumination region clearer.

When low beam illumination is required, the high beam light source 21 is turned off, and the light emitted by the low beam light source 11 forms the low beam light shape as shown in Figure 7. When high beam illumination is required, the low beam light source 11 and the high beam light source 21 are turned on at the same time. The light emitted by the low beam light source 11 forms the low beam light shape with the bright-dark cut-off line in the upper part as shown in Figure 7, and the light emitted by the high beam light source 21 forms the ADB high beam illumination region with the bright-dark cut-off line in the lower part as shown in Figure 8. The ADB high beam illumination region is combined with the low beam light shape to form the ADB high beam light shape as shown in Figure 9. Due to the fact that the bright-dark cut-off line in the lower part of the ADB high beam illumination region and the bright-dark cut-off line in the upper part of the low beam light shape are both formed by shielding by the cut-off line structure 31, the size and shape of the two are consistent, allowing the ADB high beam illumination region to perfectly match the low beam light shape in the bright-dark cut-off line region, ensuring the uniformity of the combined ADB high beam light shape. It can be seen that the ADB high and low beam integrated vehicle lamp illumination module of the present invention switches between the high beam light shape and the low beam light shape by controlling the on-off of the high beam light source 21, without the need to move the light shielding plate 3. The switching between the high beam light shape and the low beam light shape is faster and more convenient. When an ADB function needs to be executed, one corresponding high beam light source 21 is turned off, and an illuminated dark region is formed in the corresponding part of the ADB high beam illumination region, so as to form the ADB high beam light shape with the illuminated dark region as shown in Figure 10. Due to the fact that the ADB high beam illumination region only includes a region above the bright-dark cut-off line, the formed illuminated dark region is only the part above the bright-dark cut-off line, and the low beam light shape part below the bright-dark cut-off line remains in an illumination state, avoiding the formation of an excessive illuminated dark region that affects observation of a vehicle driver on the road surface and poses safety hazards. The low beam illumination region below the bright-dark cut-off line is located at a lower position, which will not cause dazzle to traffic participants in front of the vehicle and will not have a negative impact on the ADB function.

In some embodiments of the ADB high and low beam integrated vehicle lamp illumination module of the present invention, as shown in Figure 1 to Figure 6, Figure 13, Figure 14, Figure 16, and Figure 17, the high beam condensing element 22 uses the parabolic reflector. The plurality of high beam condensing elements 22 are provided, and the quantity of the high beam condensing elements 22 is consistent with the quantity of the high beam light sources 21. Each high beam light source 21 is respectively disposed at the focus of one corresponding high beam condensing element 22. The light emitted by each high beam light source 21 is reflected by the corresponding parabolic reflector, and then forms parallel collimated light to be emitted, thus forming their respective light distributions. The high beam light source 21 preferably uses an LED light-emitting chip or other surface light sources to facilitate the formation of boundaries for light distribution. The high beam light source 21 may be installed on a supporting radiator 6 to reduce a working temperature of the high beam light source 21, improve stability of the high beam light source 21, and prolong a service life of the high beam light source 21. Reflecting surfaces of the plurality of high beam condensing elements 22 may be disposed in the region of the first focus F 1 of the bifocal optical element 23, or the high beam condensing element 22 is set to be capable of collimating the light emitted by the high beam light source 21 and then irradiating it to the region of the first focus F1 of the bifocal optical element 23, so as to form the ADB primary light distribution in the region of the first focus F 1 of the bifocal optical element 23.

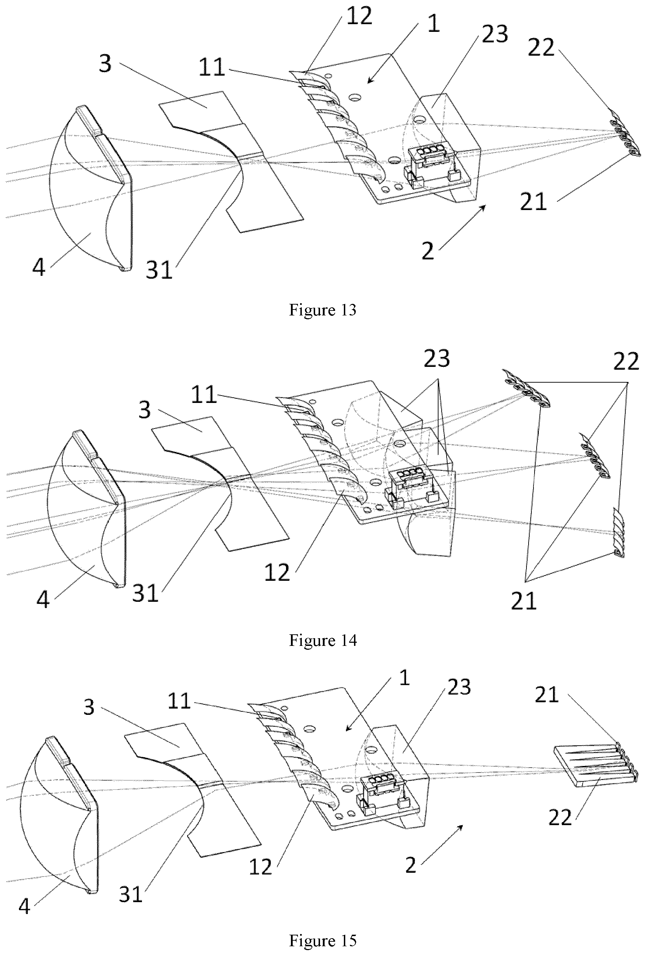

In some embodiments of the ADB high and low beam integrated vehicle lamp illumination module of the present invention, as shown in Figure 1 to Figure 6, Figure 14, Figure 16, and Figure 17, there are a plurality of bifocal optical elements 23. The quantity of the bifocal optical elements 23 may be consistent with the quantity of the high beam condensing elements 22, so that each high beam condensing element 22 can form one ADB primary light distribution at the first focus F1 of the corresponding bifocal optical element 23. After being converted by their respective corresponding bifocal optical elements 23, the plurality of ADB primary light distributions are combined at the same second focus F2 of the plurality of bifocal optical elements 23 to form the ADB secondary light distribution. In this way, each ADB primary light distribution can be closer to the focal region of the bifocal optical element 23, and the formed illumination region is clearer. At the same time, each ADB primary light distribution can also be individually adjusted through the bifocal optical element 23, thus optimizing the final formed ADB high beam light shape. However, due to the large quantity of the bifocal optical elements 23, the costs of processing and debugging also increase. As shown in Figure 14, the quantity of the bifocal optical elements 23 may also be less than the quantity of the high beam condensing elements 22, so that the light distributions formed by the plurality of high beam condensing elements 22 can be combined at the first focus F1 of one corresponding bifocal optical element 23 to form one ADB primary light distribution. After being converted by their respective corresponding bifocal optical elements 23, the plurality of ADB primary light distributions are combined at the same second focus F2 of the plurality of bifocal optical elements 23 to form the ADB secondary light distribution. In this way, the quantity of the used bifocal optical elements 23 is small, and the costs of processing and debugging are low as well.

As a specific implementation of the ADB high and low beam integrated vehicle lamp illumination module of the present invention, as shown in Figure 15, the high beam condensing element 22 uses a transparent optical guide condensing piece. The transparent optical guide condensing piece has a plurality of light incident surfaces, and each light incident surface is provided with one high beam light source 21. The light emitted by the high beam light source 21 can enter the transparent optical guide condensing piece through each corresponding light incident surface, be transmitted through the transparent optical guide condensing piece, and then be emitted from a light exit surface of the transparent optical guide condensing piece. A light exit surface of the high beam condensing element 22 is disposed in the region of the first focus F1 of the bifocal optical element 23, so that the light emitted by the light exit surface of the high beam condensing element 22 can form the ADB primary light distribution in the region of the first focus F1 of the bifocal optical element 23. The plurality of high beam condensing elements 22 may also be provided, and each high beam condensing element 22 corresponds to one or more high beam light sources 1, so as to improve the resolution of the finally formed ADB high beam illumination region.

As a specific implementation of the ADB high and low beam integrated vehicle lamp illumination module of the present invention, the high beam condensing element 22 is the ellipsoidal reflector. The plurality of high beam condensing elements 22 are provided, each high beam light source 21 is disposed at a focus of one high beam condensing element 22, and each high beam condensing element 22 can reflect the light emitted by one high beam light source 21 and then converge the light to the other focus of the high beam condensing element 22, so as to form a light distribution. The other focuses of the plurality of high beam condensing elements 22 are disposed in the region of the first focus F1 of the bifocal optical element 23, and the light distribution formed by each high beam light source 21 is combined in the region of the first focus F1 of the bifocal optical element 23 to form the ADB primary light distribution.

In some embodiments of the ADB high and low beam integrated vehicle lamp illumination module of the present invention, as shown in Figure 1 to Figure 6, Figure 16, and Figure 17, the bifocal optical element 23 is the ellipsoidal reflector. The ellipsoidal reflecting surface or quasi ellipsoidal reflecting surface of the ellipsoidal reflector has two focuses. The light emitted from one focus, after being reflected by the ellipsoidal reflecting surface or quasi ellipsoidal reflecting surface, can be converged to the other focal region. Therefore, the light distribution in one focal region may be reflected by the reflecting surface and then converged to the other focal region to form a new light distribution. According to the design requirements, the region of the first focus F1 of each bifocal optical element 23 may be provided with one condensing element 22 or the plurality of condensing elements 22. The ellipsoidal reflector can converge incident light irradiating from different directions to the first focus F1 to the region of the second focus F2, with less restriction on an included angle between the emission light and the incident light and more flexible position setting of the bifocal optical element 23 and its first focus F1.

In some embodiments of the ADB high and low beam integrated vehicle lamp illumination module of the present invention, as shown in Figure 13 to Figure 15, the bifocal optical element 23 uses the convex lens or the lens group. There is one focus on both sides of the convex lens or the lens group respectively, so that the convex lens or the lens group has two focuses. After being refracted by the convex lens or the lens group, the light emitted from one focus can be converged to the other focal region. Therefore, the ADB primary light distribution formed by the condensing element 22 in the region of the first focus F1 of the convex lens or the lens group may be converted from the region of the first focus F 1 to the region of the second focus F2, so as to form the ADB secondary light distribution. However, when using the single convex lens as the bifocal optical element 23, the overall propagation of the light refracted by the convex lens in an optical axis direction of the convex lens limits a distance of the first focus F1 of the bifocal optical element 23 deviating from the optical axis of the collimating optical element 4, and affects the flexibility of module setting.

In some embodiments of the ADB high and low beam integrated vehicle lamp illumination module of the present invention, as shown in Figure 1 to Figure 6, and Figure 13 to Figure 16, the low beam condensing element 12 is the ellipsoidal reflector. The low beam light source 11 is disposed at a focus of the low beam condensing element 12, and the light emitted by the low beam light source 11 is reflected by the low beam condensing element 12 and then converged to the other focus of the low beam condensing element 12, so as to form the low beam light distribution. The other focus of the low beam condensing element 12 is disposed in the focal region of the collimating optical element 4, and in this way, the low beam light distribution is also formed in the focal region of the collimating optical element 4. The low beam light distribution is shielded by the light shielding plate 3 and then projected out by the collimating optical element 4, so as to form the low beam light shape.

As a specific implementation of the ADB high and low beam integrated vehicle lamp illumination module of the present invention, as shown in Figure 1 to Figure 6, and Figure 13 to Figure 17, the plurality of low beam light sources 11 and the plurality of low beam condensing elements 12 are provided. The quantity of the low beam light sources 11 and the quantity of the low beam condensing elements 12 are the same, and each low beam condensing element 12 corresponds to one low beam light source 11 to be able to collimate or converge the light emitted by each low beam light source 11, and then form one light distribution in the focal region of the collimating optical element 4. The light distributions formed by the light emitted by the plurality of low beam light sources 11 are combined in the focal region of the collimating optical element 4, so as to form the low beam light distribution.

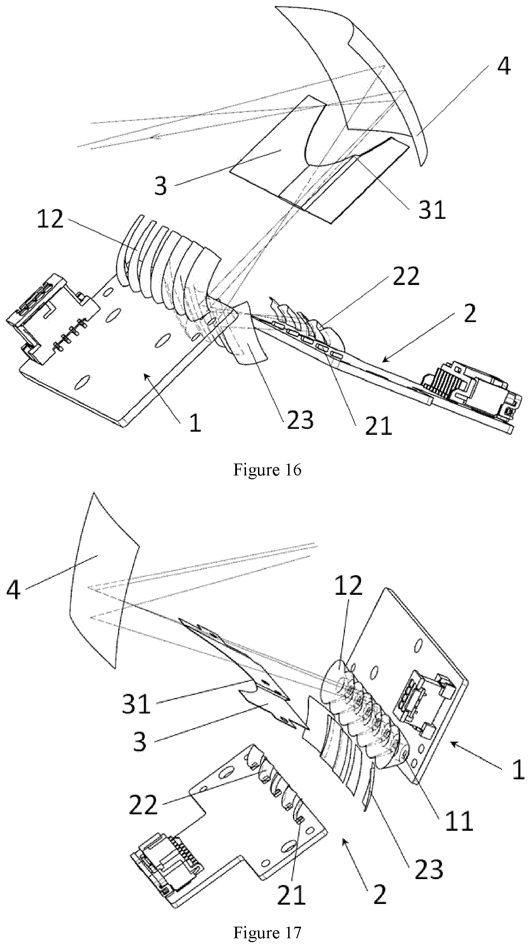

In some embodiments of the ADB high and low beam integrated vehicle lamp illumination module of the present invention, as shown in Figure 17, the low beam condensing element 12 is the transparent optical guide condensing piece. The low beam light source 11 is disposed at the light incident surface of the low beam condensing piece 12, the light emitted by the low beam light source 11 enters the transparent optical guide condensing piece through the light incident surface, and after being refracted and reflected by the transparent optical guide condensing piece, the light emitted by the low beam light source 11 forms the collimated light and emits from the light exit surface, so as to form the low beam light distribution in the focal region of the collimating optical element 4.

In some embodiments of the ADB high and low beam integrated vehicle lamp illumination module of the present invention, as shown in Figure 1 to Figure 6, and Figure 11 to Figure 15, the collimating optical element 4 is the convex lens. The convex lens can collimate the light distribution in the focal region on one side and then project it onto the other side of the convex lens, so as to from an enlarged illumination light shape. In some other embodiments of the ADB high and low beam integrated vehicle lamp illumination module of the present invention, as shown in Figure 16 and Figure 17, the collimating optical element 4 is the parabolic reflector. The parabolic reflector can collimate the light distribution in the focal region and then project it onto the same side of the reflecting surface, so as to be projected out to from an enlarged illumination light shape.

A vehicle lamp of the present invention, which uses the ADB high and low beam integrated vehicle lamp illumination module of any embodiment of the present invention, also has the above advantages.

In the description of the present invention, description referring to the terms "one embodiment", "some embodiments", and "a specific implementation" means that the specific features, structures, materials, or characteristics described in combination with the embodiment or example are contained in at least one embodiment or example of the present invention. In the present invention, the schematic expression of the above terms does not necessarily refer to the same embodiment or example. Moreover, the described specific features, structures, materials or characteristics may be combined in a proper mode in any one or more embodiments or examples.

The preferred implementations of the present invention are described in detail above with reference to accompanying drawings, but the present invention is not limited to this. Within the scope of the technical concept of the present invention, various simple variations can be made to the technical solution of the present invention, including the combination of various technical features in any other suitable way. In order to avoid unnecessary repetition, the present invention does not separately explain various possible combinations. However, these simple variations and combinations should also be considered as disclosed content of the present invention, all of which belong to the scope of protection of the present invention.

## Claims

1. An ADB high and low beam integrated vehicle lamp illumination module comprising a low beam primary optical unit (1), a high beam primary optical unit (2), a light shielding plate (3) and a collimating optical element (4), wherein the low beam primary optical unit (1) comprises a low beam light source (11) and a low beam condensing element (12), the low beam condensing element (12) is suitable for collecting light emitted by the low beam light source (11) so as to form a low beam light distribution in a focal region of the collimating optical element (4), the high beam primary optical unit (2) comprises a plurality of high beam light sources (21), a high beam condensing element (22) and a bifocal optical element (23), the high beam condensing element (22) is suitable for collecting light emitted by the plurality of high beam light sources (21) and the light is irradiated to a region of a first focus of the bifocal optical element (23), a second focus of the bifocal optical element (23) is disposed in the focal region of the collimating optical element (4), a cut-off line structure (31) is disposed on one side of the light shielding plate (3), and the cut-off line structure (31) is disposed in the focal region of the collimating optical element (4).

2. The ADB high and low beam integrated vehicle lamp illumination module of claim 1, **characterized in that** a plurality of high beam condensing elements (22) is provided, the respective high beam condensing element (22) is a parabolic reflector, each high beam light source (21) is respectively disposed in the focal region of a corresponding one of the high beam condensing elements (22), and reflecting surfaces of the plurality of high beam condensing elements (22) are all disposed in the region of the first focus of the bifocal optical element (23).

3. The ADB high and low beam integrated vehicle lamp illumination module of claim 2, **characterized in that** a plurality of bifocal optical elements (23) is provided, and the region of the first focus of each bifocal optical element (23) is provided with one or more high beam condensing elements (22).

4. The ADB high and low beam integrated vehicle lamp illumination module of claim 1, **characterized in that** the high beam condensing element (22) is a transparent optical guide condensing piece, the transparent optical guide condensing piece comprises a plurality of light incident surfaces, each light incident surface of the transparent optical guide condensing piece is provided with one high beam light source (21), and a light exit surface of the transparent optical guide condensing piece is disposed in the region of the first focus of the bifocal optical element (23).

5. The ADB high and low beam integrated vehicle lamp illumination module of claim 1, **characterized in that** a plurality of high beam condensing elements (22) is provided, the respective high beam condensing element (22) is an ellipsoidal reflector, each high beam light source (21) is disposed in one focus of one high beam condensing element (22), and the other focuses of the plurality of high beam condensing elements (22) are all disposed in the region of the first focus of the bifocal optical element (23).

6. The ADB high and low beam integrated vehicle lamp illumination module of any one of claims 1 to 5, **characterized in that** the bifocal optical element (23) is an ellipsoidal reflector.

7. The ADB high and low beam integrated vehicle lamp illumination module of any one of claims 1 to 5, **characterized in that** the bifocal optical element (23) is a convex lens or a lens group.

8. The ADB high and low beam integrated vehicle lamp illumination module of any one of claims 1 to 5, **characterized in that** the low beam condensing element (12) is an ellipsoidal reflector, the low beam light source (11) is disposed in one focus of the low beam condensing element (12), and the other focus of the low beam condensing element (12) is disposed in the focal region of the collimating optical element (4).

9. The ADB high and low beam integrated vehicle lamp illumination module of claim 8, **characterized in that** a plurality of low beam light sources (11) and a plurality of low beam condensing elements (12) are provided, each low beam light source (11) is disposed in a first focus of one low beam condensing element (12), and second focuses of the plurality of low beam condensing elements (12) are all located in the focal region of the collimating optical element (4).

10. The ADB high and low beam integrated vehicle lamp illumination module of any one of claims 1 to 5, **characterized in that** the low beam condensing element (12) is a transparent optical guide condensing piece, and the low beam light source (11) is disposed on a light incident surface of the low beam condensing element (12).

11. The ADB high and low beam integrated vehicle lamp illumination module of any one of claims 1 to 5, **characterized in that** the collimating optical element (4) is a parabolic reflector or a convex lens.

12. A vehicle lamp, **characterized by** comprising the ADB high and low beam integrated vehicle lamp illumination module of any one of claims 1 to 11.
